# EUROPEAN PATENT APPLICATION

(11) **EP 4 375 684 A1**
(43) Date of publication of application: **29.05.2024**
(21) Application number: 23801661.2
(22) Date of filing: 27.09.2023
(51) Int. Cl.: G01R 31/08

(54) **MONITORING METHOD, SYSTEM AND APPARATUS FOR QUALITY OF HIGH-FREQUENCY EXTERNAL POWER GRID**

(30) Priority: 03.03.2023 CN 202310199030
(71) Applicant: CRSC RESEARCH & DESIGN INSTITUTE GROUP CO., LTD., Fengtai District Beijing 100070 (CN)
(72) Inventor: YANG, Xiaodong, Fengtai District Beijing 100070 (CN); LIN, Zhengwei, Fengtai District Beijing 100070 (CN); HE, Dan, Fengtai District Beijing 100070 (CN)
(74) Representative: Meissner Bolte Partnerschaft mbB
(86) International application number: PCT/CN2023/122179
(87) International publication number: WO 2024/078344

(57) **Abstract**

The present invention relates to the field of quality monitoring technologies for external power grids, in particular to a method, a system, and an apparatus for monitoring the quality of a high-frequency external power grid. The method includes: acquiring current and voltage data inputted from the external power grid; transmitting the acquired current and voltage data to a station monitoring computer; processing and storing the current and voltage data by the station monitoring computer; and determining whether an alarm is given based on a processing result. According to the present invention, an external power grid acquisition unit with high-frequency sampling is used at a hardware level, a high-broadband communication channel is used at a communication level, and data uploaded by a lower computer is analyzed in real time and is stored and displayed at a software level. Through the data analysis and processing, a detailed curve shape and a value of each sampling point can be viewed on a software interface. Sampling is performed for 800 times per second, and an accuracy of a curve reaches 1.25 ms. Moreover, wave curve data is stored in a file form in a magnetic disk for an electrical depot to view at any time, thereby helping to analyze a fault condition.

## Description

### TECHNICAL FIELD

The present invention relates to the field of quality monitoring technologies for external power grids, in particular to a method, a system, and an apparatus for monitoring the quality of a high-frequency external power grid.

### BACKGROUND

With the sustained and rapid development of China's economy, railway construction is also developing at a high speed. A large amount of signal equipment is used in railways and needs to be monitored in real time, so a centralized railway signal monitoring system emerges. The centralized railway signal monitoring system plays a crucial role in ensuring the safety of train operation, monitoring statuses of the signal equipment, discovering hidden dangers of the signal equipment, and analyzing fault causes of the signal equipment.

At present, for the centralized railway signal monitoring system, one or several sets of power supply equipment for an external power grid have to be mounted at each station. The acquisition of the equipment for the external power grid is divided into lines I and II, with each line divided into phases A, B, and C. A waveform actually acquired by each phase is divided into two categories of a voltage and a current. However, an existing device for monitoring the quality of an external power grid has a low sampling frequency and thus cannot monitor abnormal fluctuations and momentary outage data of greater than 2 ms and cannot provide real-time and accurate data for an electrical depot to analyze faults and safety hazards of the equipment for the external power grid.

In order to solve the above problems, a method, a system, and an apparatus for monitoring the quality of a high-frequency external power grid need to be designed.

### SUMMARY

In view of the above problems, the present invention provides a method for monitoring the quality of a high-frequency external power grid, the method including:
acquiring current and voltage data inputted from the external power grid;
transmitting the acquired current and voltage data to a station monitoring computer;
processing and storing the current and voltage data by the station monitoring computer; and
determining whether an alarm is given based on a processing result.

Preferably, the processing the current and voltage data by the station monitoring computer includes: collating and drawing the current and voltage data into a high-frequency curve image.

Preferably, after processing the current and voltage data by the station monitoring computer, the method further includes: displaying the high-frequency curve image on an interface.

Preferably, the determining whether an alarm is given based on a processing result includes:
when a difference value between an input voltage and a rated voltage is greater than a first voltage threshold or less than a second voltage threshold and a duration is greater than a second time threshold, giving an alarm for an electrical characteristic exceeding a limit;
when the input voltage is less than a third voltage threshold and the duration is greater than the second time threshold, giving an alarm for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

The present invention further proposes a system for monitoring the quality of a high-frequency external power grid, the system including a data acquisition module, a data transmission module, a data processing module, and an alarm module;
where the data acquisition module is configured to acquire current and voltage data inputted from the external power grid;
the data transmission module is configured to transmit the acquired current and voltage data to a station monitoring computer;
the data processing module is configured to process and store the current and voltage data by the station monitoring computer; and
the alarm module is configured to determine whether an alarm is given based on a processing result.

Preferably, the data processing module being configured to process and store the current and voltage data by the station monitoring computer refers to that
the data processing module is configured to collate and draw the current and voltage data into a high-frequency curve image.

Preferably, the data processing module being configured to process and store the current and voltage data by the station monitoring computer further refers to that
the data processing module is configured to display the high-frequency curve image on an interface.

Preferably, the alarm module being configured to determine whether an alarm is given based on a processing result refers to that
when a difference value between an input voltage and a rated voltage is greater than a first voltage threshold or less than a second voltage threshold and a duration is greater than a second time threshold, giving an alarm for an electrical characteristic exceeding a limit;
when the input voltage is less than a third voltage threshold and the duration is greater than the second time threshold, giving an alarm for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

The present invention further proposes an apparatus for monitoring the quality of a high-frequency external power grid, the apparatus including an external power grid acquisition unit, a communication module, and a station monitoring computer;
where the external power grid acquisition unit is connected to the communication module via a wire, and the communication module is connected to the station monitoring computer via a wire;
the external power grid acquisition unit is configured to acquire current and voltage data inputted from the external power grid;
the communication module is configured to transmit the acquired current and voltage data to the station monitoring computer; and
the station monitoring computer is configured to process and store the current and voltage data and to determine whether an alarm is given based on a processing result.

The present invention further proposes an electronic device for monitoring the quality of a high-frequency external power grid, including a processor, a communication interface, a memory, and a communication bus, where the processor, the communication interface, and the memory communicate with one another via the communication bus;
the memory is configured to store a computer program; and
the processor is configured to, when executing the program stored on the memory, implement steps of the above method.

The present invention further proposes a computer-readable storage medium having a computer program stored thereon,
where the computer program, when executed by a processor, implements steps of the above method.

The present invention has the following beneficial effects:
According to the present invention, an external power grid acquisition unit with high-frequency sampling is used at a hardware level, a high-broadband communication channel is used at a communication level, and data uploaded by a lower computer is analyzed in real time and is stored and displayed at a software level. Through the data analysis and processing, a detailed curve shape and a value of each sampling point can be viewed on a software interface. Sampling is performed for 800 times per second, and an accuracy of a curve reaches 1.25 ms. Moreover, wave curve data is stored in a file form in a magnetic disk for an electrical depot to view at any time, thereby helping to analyze a fault condition.

Other features and advantages of the present invention will be described in the following specification, and will become apparent in part from the specification, or will be understood by implementing the present invention. The objective and other advantages of the present invention may be achieved and obtained through the structures indicated in the specification and the accompanying drawings.

### BRIEF DESCRIPTION OF THE DRAWINGS

To more clearly illustrate the technical solutions in the embodiments of the present invention or in the prior art, the accompanying drawings that need to be used in the description of the embodiments or the prior art will be briefly described below. Apparently, the accompanying drawings in the description below merely illustrate some embodiments of the present invention. Those of ordinary skill in the art may also derive other accompanying drawings from these accompanying drawings without creative efforts.
FIG 1 shows a flowchart of a method for monitoring the quality of a high-frequency external power grid in an embodiment of the present invention;
FIG 2 shows a schematic diagram of giving an alarm by software in an embodiment of the present invention;
FIG 3 shows a diagram of a system for monitoring the quality of a high-frequency external power grid in an embodiment of the present invention;
FIG 4 shows a diagram of an apparatus for monitoring the quality of a high-frequency external power grid in an embodiment of the present invention; and
FIG 5 shows a diagram of an electronic device in an embodiment of the present invention.

### DETAILED DESCRIPTION OF THE EMBODIMENTS

To make the objectives, technical solutions and advantages of the embodiments of the present invention clearer, the technical solutions in the embodiments of the present invention will be clearly and completely described below with reference to the accompanying drawings in the embodiments of the present invention. Apparently, the described embodiments are a part rather than all of the embodiments of the present invention. All other embodiments obtained by those of ordinary skill in the art based on the embodiments of the present invention without creative efforts shall fall within the scope of protection of the present invention.

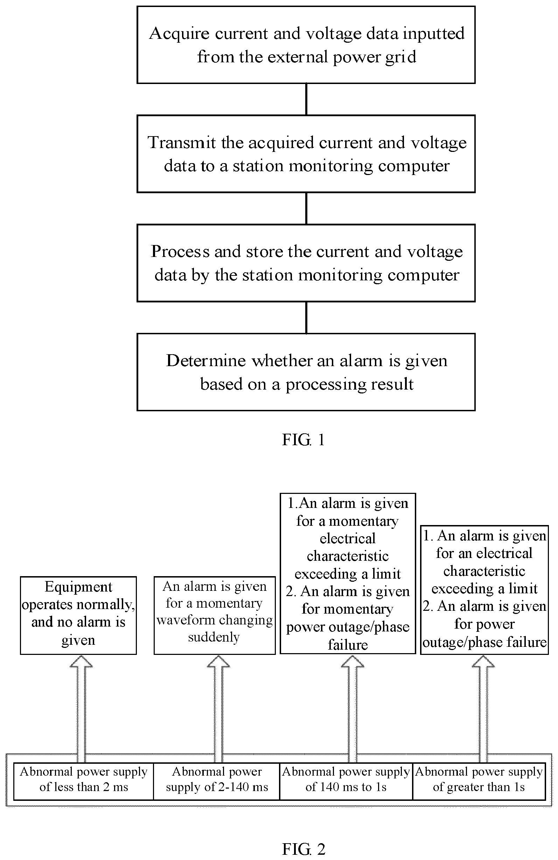

As shown in FIG 1, the present invention proposes a method for monitoring the quality of a high-frequency external power grid, including the following steps:
(1): acquiring current and voltage data inputted from the external power grid.
   In this embodiment, an acquisition frequency is 800 Hz, 16 points are sampled in each period, and an acquisition accuracy is 1.25 ms.
(2): transmitting the acquired current and voltage data to a station monitoring computer.
(3): processing and storing the current and voltage data by the station monitoring computer.

The processing the current and voltage data by the station monitoring computer includes: collating and drawing the current and voltage data into a high-frequency curve image.

After processing the current and voltage data by the station monitoring computer, the method further includes: displaying the high-frequency curve image on an interface.
(4): determining whether an alarm is given based on a processing result.

As shown in FIG. 2, when a difference value between an input voltage and a rated voltage is greater than a first voltage threshold or less than a second voltage threshold and a duration is greater than a second time threshold, an alarm is given for an electrical characteristic exceeding a limit;
when the input voltage is less than a third voltage threshold and the duration is greater than the second time threshold, an alarm is given for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

In this embodiment, the first voltage threshold is 15% of the rated voltage, the second voltage threshold is 20% of the rated voltage, the third voltage threshold is 65% of the rated voltage, the fourth voltage threshold is 30% of the rated voltage, the first time threshold is 140 ms, the second time threshold is 1,000 ms, and the third time threshold is 2 ms. The above voltage thresholds and time thresholds are not constant and may be adjusted according to an actual situation, and the rated voltage is set by equipment leaving the factory and is not a fixed value.

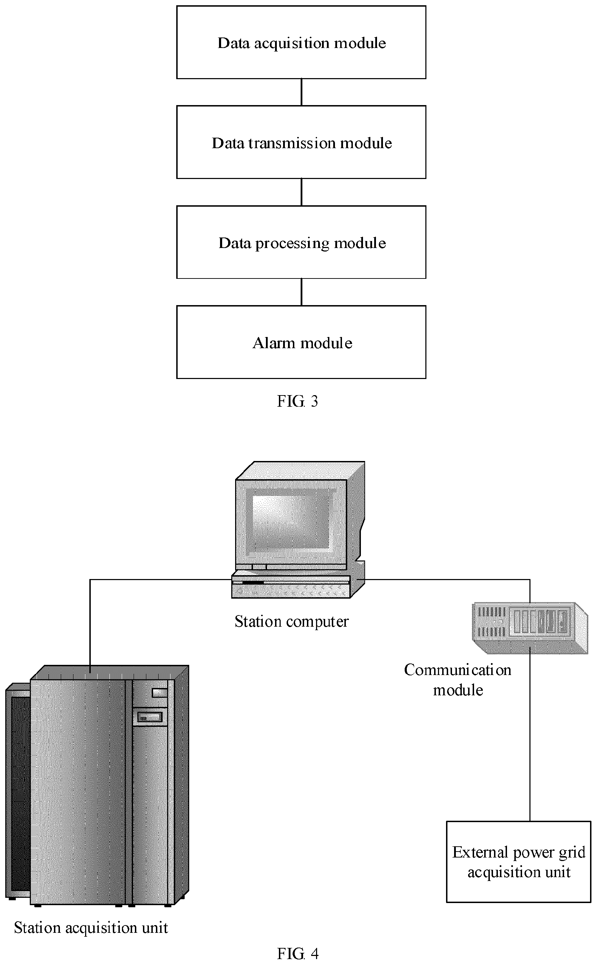

As shown in FIG. 3, the present invention further proposes a system for monitoring the quality of a high-frequency external power grid, the system including a data acquisition module, a data transmission module, a data processing module, and an alarm module.

The data acquisition module is configured to acquire current and voltage data inputted from the external power grid. In this embodiment, an acquisition frequency of the data acquisition module is 800 Hz, 16 points are sampled in each period, and an acquisition accuracy is 1.25 ms.

The data transmission module is configured to transmit the acquired current and voltage data to a station monitoring computer.

The data processing module being configured to process and store the current and voltage data by the station monitoring computer refers to that the data processing module is configured to collate and draw the current and voltage data into a high-frequency curve image and to display the high-frequency curve image on an interface. Specifically, the data processing module analyzes the acquired current and voltage data, identifies a voltage/current type of a phase A/B/C in a line I/II, generates a corresponding curve identifier (ID), and converts curve point data according to a rate agreed in a protocol to calculate an actual value of a curve point, so as to form high-frequency curve data. Then the high-frequency curve data is stored in a magnetic disk file and is displayed on a millisecond level interface. A curve uses an abscissa as a time axis and an ordinate as an actual voltage/current. An alarm is given when the voltage or the current exceeds a defined deviation.

The alarm module being configured to determine whether an alarm is given based on a processing result refers to that
when a difference value between an input voltage and a rated voltage is greater than a first voltage threshold or less than a second voltage threshold and a duration is greater than a second time threshold, an alarm is given for an electrical characteristic exceeding a limit;
when the input voltage is less than a third voltage threshold and the duration is greater than the second time threshold, an alarm is given for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

As shown in FIG 4, the present invention further proposes an apparatus for monitoring the quality of a high-frequency external power grid, the apparatus including an external power grid acquisition unit, a communication module, and a station monitoring computer;
where the external power grid acquisition unit is connected to the communication module via a wire, and the communication module is connected to the station monitoring computer via a wire;
the external power grid acquisition unit is configured to acquire current and voltage data inputted from the external power grid;
the communication module is configured to transmit the acquired current and voltage data to the station monitoring computer; and
the station monitoring computer is configured to process and store the current and voltage data and to determine whether an alarm is given based on a processing result.

The apparatus further includes an ordinary station acquisition unit connected to the station computer via a wire and configured to acquire non-high-frequency data. Specifically, the ordinary station acquisition unit includes interlocking equipment, train control equipment, a track circuit, ZPW equipment, and other equipment.

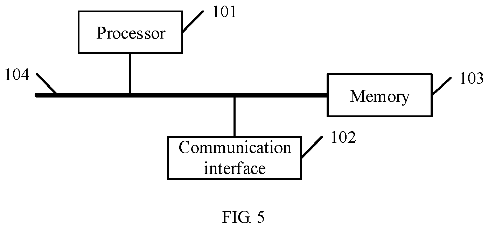

As shown in FIG. 5, the present invention further proposes an electronic device for monitoring the quality of a high-frequency external power grid, including a processor 101, a communication interface 102, a memory 103, and a communication bus 104, where the processor 101, the communication interface 102, and the memory 103 communicate with one another via the communication bus 104; and the memory 103 is configured to store a computer program.

In an embodiment of the present invention, the processor 101 is configured to, when executing the program stored on the memory 103, implement steps of a method for monitoring the quality of a high-frequency external power grid provided by any one of the foregoing method embodiments.

The implementation principle and technical effects of the electronic device provided by the embodiment of the present invention are similar to those of the above embodiments, and will not be repeated herein.

The memory 103 may be an electronic memory such as a flash memory, an electrically erasable programmable read-only memory (EEPROM), an erasable programmable read-only memory (EPROM), a hard disk, or a read-only memory (ROM). The memory 103 has a storage space for program codes used to execute any method steps in the above method. For example, the storage space for the program codes may include the various program codes used to implement the various steps in the above method, respectively. These program codes may be read from or written into one or more computer program products. These computer program products include program code carriers such as hard disks, compact discs (CDs), memory cards, or floppy disks. Such computer program product is usually a portable or fixed memory cell. The memory cell may have a memory segment or a storage space arranged similarly to that of the memory 103 in the above electronic device. The program codes may be compressed in an appropriate form, for example. Generally, the memory cell includes a program for executing the method steps according to the embodiment of the present invention, that is, codes that can be read by a processor such as the processor 101. These codes, when run by an electronic device, causes the electronic device to perform the various steps in the method described above.

An embodiment of the present invention further provides a computer-readable storage medium. The computer-readable storage medium has a computer program stored thereon, where the computer program, when executed by a processor, implements steps of the method for monitoring the quality of a high-frequency external power grid as described above.

The computer-readable storage medium may be included in the device/apparatus described in the above embodiments, or may exist alone without being assembled into the device/apparatus. The computer-readable storage medium carries one or more programs which, when executed, implement the method according to the embodiment of the present invention.

According to the embodiment of the present invention, the computer-readable storage medium may be a non-volatile computer-readable storage medium, which, for example, may include, but is not limited to, a portable computer disk, a hard disk, a random access memory (RAM), a read-only memory (ROM), an erasable programmable read-only memory (EPROM or flash memory), a portable compact disc read-only memory (CD-ROM), an optical storage device, a magnetic storage device, or any suitable combination thereof. In the present invention, the computer-readable storage medium may be any tangible medium containing or storing a program which may be used by or in combination with an instruction execution system, apparatus, or device.

It should be understood by those of ordinary skill in the art that while the present invention has been described in detail with reference to the foregoing embodiments, they may still perform modifications on the technical solutions described in the foregoing embodiments or perform equivalent substitutions on some of the technical features therein; and these modifications or substitutions do not make the essence of the corresponding technical solutions depart from the spirit and scope of the technical solutions in the embodiments of the present invention.

## Claims

1. A method for monitoring the quality of a high-frequency external power grid, **characterized by** comprising:
acquiring current and voltage data inputted from the external power grid;
transmitting the acquired current and voltage data to a station monitoring computer;
processing and storing the current and voltage data by the station monitoring computer; and
determining whether an alarm is given based on a processing result.

2. The method for monitoring the quality of a high-frequency external power grid according to claim 1, **characterized in that**
the processing the current and voltage data by the station monitoring computer comprises: collating and drawing the current and voltage data into a high-frequency curve image.

3. The method for monitoring the quality of a high-frequency external power grid according to claim 2, **characterized in that**
after processing the current and voltage data by the station monitoring computer, the method further comprises: displaying the high-frequency curve image on an interface.

4. The method for monitoring the quality of a high-frequency external power grid according to claim 1, **characterized in that**
the determining whether an alarm is given based on a processing result comprises:
when a difference value between an input voltage and a rated voltage is greater than a first voltage threshold or less than a second voltage threshold and a duration is greater than a second time threshold, giving an alarm for an electrical characteristic exceeding a limit;
when the input voltage is less than a third voltage threshold and the duration is greater than the second time threshold, giving an alarm for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

5. A system for monitoring the quality of a high-frequency external power grid, **characterized by** comprising a data acquisition module, a data transmission module, a data processing module, and an alarm module;
wherein the data acquisition module is configured to acquire current and voltage data inputted from the external power grid;
the data transmission module is configured to transmit the acquired current and voltage data to a station monitoring computer;
the data processing module is configured to process and store the current and voltage data by the station monitoring computer; and
the alarm module is configured to determine whether an alarm is given based on a processing result.

6. The system for monitoring the quality of a high-frequency external power grid according to claim 5, **characterized in that**
the data processing module being configured to process and store the current and voltage data by the station monitoring computer refers to that
the data processing module is configured to collate and draw the current and voltage data into a high-frequency curve image.

7. The system for monitoring the quality of a high-frequency external power grid according to claim 5, **characterized in that**
the data processing module being configured to process and store the current and voltage data by the station monitoring computer further refers to that
the data processing module is configured to display the high-frequency curve image on an interface.

8. The system for monitoring the quality of a high-frequency external power grid according to claim 5, **characterized in that**
the alarm module being configured to determine whether an alarm is given based on a processing result refers to that
when a difference value between an input voltage and a rated voltage is greater than a first voltage threshold or less than a second voltage threshold and a duration is greater than a second time threshold, giving an alarm for an electrical characteristic exceeding a limit;
when the input voltage is less than a third voltage threshold and the duration is greater than the second time threshold, giving an alarm for power outage and phase failure;
when the input voltage is less than the third voltage threshold and the duration is between a first time threshold and the second time threshold, giving an alarm for momentary power outage/phase failure;
when the input voltage is greater than the first voltage threshold or less than the second voltage threshold and the duration is between the first time threshold and the second time threshold, giving an alarm for a momentary electrical characteristic exceeding the limit; and
when an absolute value of the input voltage is greater than a fourth voltage threshold and the duration is greater than a third time threshold, giving an alarm for a momentary waveform changing suddenly.

9. An apparatus for monitoring the quality of a high-frequency external power grid, **characterized by** comprising an external power grid acquisition unit, a communication module, and a station monitoring computer;
wherein the external power grid acquisition unit is connected to the communication module via a wire, and the communication module is connected to the station monitoring computer via a wire;
the external power grid acquisition unit is configured to acquire current and voltage data inputted from the external power grid;
the communication module is configured to transmit the acquired current and voltage data to the station monitoring computer; and
the station monitoring computer is configured to process and store the current and voltage data and to determine whether an alarm is given based on a processing result.

10. An electronic device for monitoring the quality of a high-frequency external power grid, **characterized by** comprising a processor, a communication interface, a memory, and a communication bus, wherein the processor, the communication interface, and the memory communicate with one another via the communication bus;
the memory is configured to store a computer program; and
the processor is configured to, when executing the program stored on the memory, implement steps of the method according to any one of claims 1 to 4.

11. A computer-readable storage medium having a computer program stored thereon, **characterized in that**
the computer program, when executed by a processor, implements steps of the method according to any one of claims 1 to 4.
